# EUROPEAN PATENT APPLICATION

(11) **EP 4 614 230 A1**
(43) Date of publication of application: **10.09.2025**
(21) Application number: 24161275.3
(22) Date of filing: 04.03.2024
(51) Int. Cl.: G03F 7/20

(54) **BEAM TRAVELLING CARRIAGE**

(71) Applicant: Mycronic AB, 183 03 Täby (SE)
(72) Inventor: Rådahl, Simon, 184 92 Åkersberga (SE); Mattsson, Daniel, 197 36 Bro (SE)
(74) Representative: AWA Sweden AB

(57) **Abstract**

A beam-travelling carriage is provided. The carriage comprises a top plate, a side plate, and a hinge connecting a first lateral edge of the top plate to an upper edge of the side plate. The top plate has a bottom surface on which at least one first air bearing is arranged for enabling linear motion of the top plate along an upper surface of a horizontal beam. The side plate has a lateral surface on which at least one second air bearing is arranged for enabling linear motion of the side plate along a first lateral surface of the horizontal beam. The at least one second air bearing is preloaded to control a distance between the side plate and the first lateral surface of the horizontal beam.

## Description

### Technical field

The present disclosure relates generally to the field of pattern generators. More specifically, it relates to a beam-travelling carriage.

### Background

Pattern generators, such as mask writers, are used to generate or write highly detailed patterns into or onto a substrate. The patterned substrate may for example be treated to produce a photo mask.

An example of a pattern generation process is optical microlithography, in which an optical beam, such as a laser beam or other writing beam, is focused onto a substrate using projection optics. The optical beam may expose a photo-sensitive resist provided on the substrate to generate a pattern. Optical microlithography can create exceedingly small patterns, down to nanometer size, and provide a precise control of the design and position of the pattern on the substrate. It is therefore crucial that the beam is correctly positioned on the substrate, and correctly focused at the substrate.

Mura effects/defects are interference patterns caused by periodicity in the pattern generator system. The interference effects/patterns may remain in the patterned substrate, and may transfer into e.g., a photomask produced from the substrate, and onto a product manufactured using such a photomask. Such products may for example include different types of displays and screens, in which the mura effects may be perceptible for the human vision. Mura is still a substantial challenge in the field and usually cause significant work and delays at set-up and installation. There are several different potential sources for mura, but many can be related to vibrations in the structure holding the projection optics.

In some systems, the projection optics are arranged in a so-called optical head. The optical head is mounted on a carriage, which is arranged to travel along a beam positioned above a stage on which the substrate may be held. The movement of the carriage along the beam allows the projection optics to expose the substrate along the travel direction, i.e., to scan the optical beam along the substrate. By modulating the optical beam during the scan, different positions on the photo-sensitive resist may develop differently, and a pattern may be formed on the substrate.

The movement of the carriage along the beam may cause vibrations, which in turn may result in mura effects in the pattern. Vibrations in the carriage and/or optical head may result in variations in the focus of the optical beam on the substrate. Such vibrations may for example be caused by defects of the beam, or a natural frequency in the carriage.

There is therefore a need for an improved beam-travelling carriage to meet and improve the standards of microlithography processes.

### Summary

It is therefore an object of the present invention to overcome at least some of the above-mentioned drawbacks, and to provide an improved solution for reducing mura in pattern generation.

This and other objects are achieved by means of a beam-travelling carriage as defined in the appended independent claim. Other embodiments are defined by the dependent claims.

According to a first aspect of the present disclosure, a beam-travelling carriage is provided. The carriage comprises a top plate, a side plate and a hinge connecting a first lateral edge of the top plate to an upper edge of the side plate. The top plate has a bottom surface on which at least one first air bearing is arranged for enabling linear motion of the top plate along an upper surface of a horizontal beam. The side plate has a lateral surface on which at least one second air bearing is arranged for enabling linear motion of the side plate along a first lateral surface of the horizontal beam. The at least one second air bearing is preloaded for maintaining a lateral position of the carriage on the horizontal beam.

The beam-travelling carriage may for example be a beam-travelling carriage for a microlithography system. A microlithography system or process capable of generating nanoscale patterns may be referred to as a nanolithography system or process. In the below the term microlithography is used to refer to systems and processes capable of generating patterns in microscale or smaller, such as nanoscale. The beam-travelling carriage may thus be a beam-travelling carriage for a nanolithography system.

In a typical use case of the beam-travelling carriage (in the following sometimes referred to as "the carriage"), the carriage may be arranged to travel along a horizontal beam (in the following sometimes referred to as "a beam"). In the present disclosure, the term "longitudinally" will refer to a direction in which the beam-travelling carriage is configured to travel. For example, a horizontal beam, on which the beam-travelling carriage is configured to travel, may extend longitudinally. "Laterally" will describe a sideways direction in relation to the direction of travel, such as a horizontal direction orthogonal to the longitudinal direction of travel. "Top" and "upper", as well as "bottom" and "lower", and the like, may describe positions along a direction orthogonal to the longitudinal and lateral directions.

The movement of a beam-travelling carriage may be described using a cartesian coordinate system. The direction of travel, or the longitudinal direction, may be referred to as the X-direction. The lateral direction may be referred to as the Y-direction. In, e.g., a microlithography system, the beam may be arranged above a stage or a substrate holder. A direction from the carriage to the stage may be referred to as the Z-direction. The Z-direction may be parallel to a direction of gravity, and/or be orthogonal to a surface of a substrate arranged on stage below the beam.

The top plate is arranged to travel along an upper surface of a horizontal beam. The top plate has at least one first air bearing arranged in, on, or at a bottom surface of the top plate. The at least one first air bearing (or "the first air bearing") may emit a flow of air, creating an air film or cushion between the top plate and the upper beam surface. The air film or cushion may allow for low-friction travel of the carriage along the top or upper surface of the beam. The air film or cushion between the top or upper surface of the beam and the top plate of the carriage may have a thickness in the range of 2-10 µm, such as 3-8 µm, or 4-5 µm. A smaller air film thickness may increase the stability of the movement and reduce vibrations.

The first air bearing may be non-biased or non-preloaded. As the top plate is configured to travel along a top pr upper surface of the beam, gravity may bias the carriage towards the beam due to a weight of the carriage. In a microlithography setting, the carriage may for example weigh 25-40 kg, such as 30-35 kg.

The side plate is arranged to travel along a lateral (side) surface of the horizontal beam. The side plate has at least one second air bearing arranged in, on, or at a lateral surface of the side plate. The at least one second air bearing (or "the second air bearing") may emit a flow of air, creating an air film or cushion between the side plate and the lateral beam surface. The air film or cushion may allow for low-friction travel of the carriage along the lateral surface of the beam. The second air bearing is preloaded, providing a force pulling the side plate towards the lateral beam surface to balance the force from the air flow. The second air bearing may therefore maintain a lateral position of the carriage on or along the beam. The second air bearing may therefore control, maintain or provide a distance between the lateral surface of the second plate and the first lateral beam surface. The distance may be equivalent to a thickness of the air film between the lateral surface of the second plate and the first lateral beam surface. The air film or cushion between the lateral surface of the beam and the side plate of the carriage may have a thickness smaller than 8 µm, such as smaller than 4 µm, such as about 1.5-2.5 µm. A smaller air film thickness may increase the stability of the movement and reduce vibrations.

An air flow of each of the first and second air bearings may be controllable by a respective valve. An air flow through each respective valve may be individually adjustable. Further, an air supply pressure may be adjustable. Thus, the air film thickness of the bearings may be adjustable. The supply pressure may be in a range of 1.5-6 bar, such as 1.8-5 bar, or 2-3 bar.

By adjusting the air flow or pressure, the flying height of the carriage above the beam, i.e., the thickness of the air film, may be controlled. The "flying height" of the side plate is controlled with the air flow or pressure, and with control of the bias or preloading in case it is controllably biased.

Surface areas of the first and second air bearings may be maximized, in order to increase stiffness while maintaining a relatively low air pressure. A lower air pressure may increase the stability of the movement and reduce vibrations.

The top plate and/or the side plate may be made from or comprise a ceramic material. Ceramic materials may be treated to provide flat surfaces within tolerance levels required for microlithography implementations. Examples of materials from which the top plate and/or the side plate may be formed comprise diabase/dolerite/microgabbro, Zerodur, Macor or Alumina. Macor may be machinable with common machine tools, thus easier to treat. Alumina has a high elastic modulus, and may be machined, or lapped, to a high flatness.

The top plate and the side plate are connected with a hinge. The hinge may allow for some relative movement between the side plate and the top plate. Specifically, the hinge may allow rotation along a longitudinal axis. Because of the hinge, the carriage may be less affected by angular deviations of the beam, such as an angle between the upper surface and the lateral surface not being exactly orthogonal.

The beam-travelling carriage according to the first aspect of the present disclosure may be less sensitive to vibrations or may cause less vibrations when travelling along a beam.

The flexibility provided by the hinge may increase a tolerance of the carriage to angular deviations of the beam. In other words, the carriage of the present disclosure may tolerate a larger angular deviation of the beam with reduced or without vibrations.

Conventional beam-travelling carriages for microlithography often wrap around all sides of the beam, to hold on to the beam. Conventional beam-travelling carriages often have sides, parts, or portions which interact with, provide pressure on, or hold onto a plurality of sides of the beam. Conventional beam-travelling carriages may rely on structures interacting with at least a top surface and both lateral surfaces of a beam to ensure correct positioning of the carriage along the beam during travel. Often, in conventional beam-travelling carriages, structures, sides, or parts are also provided for interaction with a bottom surface of a beam, for securing the carriage to the beam. In many conventional beam-travelling carriages, a number of springs and meticulous tuning are required for the carriage to travel smoothly along the beam.

The beam-travelling carriage of the present disclosure may be made with a reduced number of parts in comparison to conventional beam-travelling carriages. For example, the present carriage may comprise the top plate and the side plate, both provided with air bearings for travelling along the beam. During travel, the present carriage may interact with the top surface of the beam, and the lateral surface of the beam, without interaction with a bottom surface of the beam or another lateral surface of the beam. As such, the beam-travelling carriage may travel along the beam without fully wrapping around the beam or grabbing onto the beam. The weight of the carriage may bias the top plate against the upper surface of the beam, and the biasing of the at least one second air bearing may full the side plate toward the lateral surface of the beam. Thus, the biased second air bearing may secure the carriage to the beam and prevent lateral movement of the carriage during travel.

The structure of the present carriage may reduce the complexity of the carriage, in comparison with prior solutions. For example, the present carriage may be made with fewer parts, such as fewer air bearings, preloaded springs, and adjustment screws, and with a reduced need for adjustment and tuning.

The reduced complexity and number of parts of the present carriage may facilitate assembly and service of the beam-travelling carriage. For example, as the carriage is secured to the beam using biased bearings, which provide an inherent damping, the present beam-travelling carriage may be assembled without, or at least with fewer, springs. Further, due to the inherent damping of the first and second air bearings, the first and second air bearings may absorb forces acting between the beam and the carriage, leading to a reduction in bending moments in the carriage and/or the beam.

Furthermore, with a reduced number of parts or components of the carriage, the carriage of the present disclosure comprises further parts or components that can vibrate. For example, with fewer components, and fewer types of components, there are fewer internal resonances to consider.

By reducing vibrations caused by, or present in, the carriage during travel, the carriage of the present disclosure may be better adapted for use in pattern generators, such as microlithography systems. The reduction in vibrations may reduce a variation in focus (or "Z-height") of the optical beam. Further, the reduction in vibrations may reduce variations in a positioning (in X and/or Y direction) of the optical beam on a substrate. Thus, use of the present carriage in a pattern generator may provide a reduction in mura, and/or an improvement in placement accuracy of the optical beam on the substrate.

It will be appreciated that a beam-travelling carriage of the present disclosure may carry or hold equipment other than an optical head of a pattern generation.

According to come embodiments, the beam-travelling carriage may further comprise at least one stopping element. The at least one stopping element may extend downward from the top plate at a second lateral edge of the top plate. The at least one stopping element is arranged to be positioned at a first distance from a second lateral surface of the horizontal beam during operation of the at least one second air bearing. In case of failed operation of the at least one second air bearing, the at least one stopping element is arranged to prevent lateral movement of the carriage.

The second lateral edge of the top plate may be opposite to the first lateral edge of the top plate. The second lateral edge may be configured to be arranged at an opposite lateral side of the beam from the first lateral surface of the beam. The stopping element may be arranged at a lateral edge of the top plate. Thus, the stopping element may be arranged near the second lateral edge of the top plate, or in a region adjacent to or neighboring the second lateral edge of the top plate. Specifically, the stopping element is arranged or positioned such that it may extend next to, or in parallel with the second lateral surface of the beam, wherein the second lateral surface of the beam is opposite to the first lateral surface of the beam. Thus, the top plate may have a width larger than a width of the beam.

The (at least one) stopping element may extend downward from the top plate, such as along the Z-direction defined above. The stopping element may be positioned and dimensioned such that the stopping element is arranged not to interact with the second lateral surface of the beam during travel of the carriage along the beam. Specifically, the stopping element may be arranged to be positioned at a first distance from the beam as the carriage travels along the beam. The first distance may be smaller than 0.3 mm, such as smaller than 0.2 mm, or smaller than 0.15 mm. The first distance may be in a range from 0.05-0.2 mm, such as 0.08-0.15 mm, or 0.1 mm. In other words, a distance between the stopping element and the side plate may be determined based on a width of the beam along which the carriage is configured to travel, such that the stopping element is positioned at the first distance from the second lateral surface during operation of the second air bearing.

As previously mentioned, the biasing of the second air bearing may pull the carriage laterally toward the beam, while the air pressure of the second air bearing pushes the carriage laterally away from second lateral surface of the beam. A balance between the pushing and pulling forces of the second air bearing(s) may secured and accurately positioned the carriage along the beam, during operation of the second air bearing.

However, if the second air bearing were to fail, or operation of the second air bearing were suddenly interrupted, the carriage may move laterally on the beam. The at least one stopping element may act as an emergency stop or break. The at least one stopping element may prevent (further) lateral movement of the carriage by engaging with, or coming into contact with, the second lateral surface of the beam. The first distance may be adjusted such that, i.e., small enough that, the biasing force provided by the preloaded or biased second air bearing can pull the carriage into the correct position when operation of the second air bearing is resumed.

According to some embodiments, the beam-travelling carriage may further comprise a counterweight arranged at a second lateral edge of the top plate.

The counterweight may be arranged near the second lateral edge of the top plate, or in a region adjacent to or neighboring the second lateral edge of the top plate. The counterweight may be arranged on top of the top plate, or at the bottom surface of the top plate.

The counterweight may be arranged at the second lateral edge of the top plate to balance an otherwise uneven weight distribution of the carriage. A weight of the counterweight may be adapted to balance the carriage. Thus, the weight of the counterweight may be adapted to a weight of the carriage and to a weight of potential equipment carried by the carriage. Specifically, the counterweight may be positioned and dimensioned to move a center of gravity of the carriage. For example, the counterweight may be positioned and dimensioned to move a center of gravity of the carriage closer to a position of a motor, actuator, or propulsion means of the carriage.

The counterweight may comprise a plate, such as a steel plate. Components, such as electronical components, of the carriage or of equipment carried by the carriage, may be arranged as part of the counterweight.

The counterweight may extend downward from the top plate. In embodiments including both a stopping element and a counterweight extending downward from a bottom surface of the top plate, the stopping element may be arranged at, or form part of, the counterweight.

According to some embodiments, the at least one second air bearing may be vacuum preloaded.

In a vacuum biased or preloaded second air bearing, the bias or preloading may be controlled using a valve. Further, the vacuum of the vacuum bias may improve ventilation of the air bearing. This may reduce an airflow at the machine, which may interfere with equipment carried by the carriage. Improved ventilation may further remove potential particles or dust present along the beam. This may be advantageous in particle sensitive applications, such as pattern generation.

A vacuum groove of a vacuum biased air bearing may be arranged surrounding the air bearing. Thus, a pushing force from the air flow from the air bearing may be better balanced by a pulling of the vacuum biasing. This may reduce deformations and stress in the side plate and/or the beam.

Further, the air bearing and the vacuum biasing may be formed from similar materials and using similar techniques, which may facilitate the construction and manufacture, and lead to a more robust structure.

A vacuum biasing may be controllable using by controlling a pressure of the vacuum and/or using controllable valves. The control may be similar to a control of the air bearing itself.

According to some embodiments, the at least one second air bearing may be magnetically preloaded.

A magnetically biased second air bearing may interact with the beam, or with a corresponding magnetic element arranged at or along the beam.

According to some embodiments, the at least one first air bearing may be integrally formed in the top plate. The at least one second air bearing may be integrally formed in the side plate.

The first and/or second air bearings may be integrally formed in the respective plates. For example, the air bearings may comprise tracks or grooves machined into the plates themselves, e.g., using milling.

According to some embodiments, the at least one first air bearing may comprise at least two longitudinally spaced first air bearings.

For example, the top plate may comprise at least one first air bearing arranged at, e.g., a front portion of the top plate, and at least one first air bearing arranged at, e.g., a back portion of the top plate. It is appreciated that the carriage may move in two directions along the beam, and that the "front" and "back" terminology may be used simply to differentiate between two sides or end portions of the carriage along the longitudinal direction.

The at least two longitudinally first air bearings may be positioned and/or dimensioned to compensate for a weight distribution of the carriage and/or equipment carried by the carriage. The at least two longitudinally spaced first air bearings may be individually controllable, e.g., using individual valves.

According to some embodiments, the bottom surface of the top plate may comprise a damping surface between the at least two longitudinally spaced first air bearings.

The damping surface may be a lapped surface between the at least two longitudinally spaced first air bearings The damping surface may have a similar film thickness as the air bearings but without any air supply. In other words, the damping surface may be level with a surface of the first air bearings. The damping surface may provide additional damping of vibrations between the carriage and the beam, and thus a smoother movement of the carriage.

According to some embodiments, the at least one first air bearing may comprise at least two laterally spaced first air bearings.

For example, the top plate may comprise at least one first air bearing arranged at, e.g., a first lateral side or portion of the top plate, and at least one first air bearing arranged at a second, opposite, lateral side or portion of the top plate.

The at least two laterally spaced first air bearings may be positioned and/or dimensioned to compensate for a weight distribution of the carriage and/or equipment carried by the carriage. The at least two laterally spaced first air bearings may be individually controllable, e.g., using individual valves.

According to some embodiments, the at least two laterally spaced first air bearings may comprise a first number of first air bearings arranged at a first lateral portion of the bottom surface of the top plate. The at least two laterally spaced first air bearings may further comprise a second number of first air bearings arranged at a second lateral portion of the bottom surface of the top plate. The first number may be larger than the second number.

For example, the bottom surface of the top plate may comprise a larger number of first air bearings at the first lateral side of the top plate, at which the side plate is arranged, than at the second lateral side of the top plate. The different number of air bearings may compensate or be adapted to the weight distribution of the carriage, to balance an off-center center of gravity. For example, the first number of first air bearings may be 4, and the second number of first air bearings may be 2. Alternatively, the first number of first air bearings may be 6, and the second number of first air bearings may be 2 or 3.

According to some embodiments, the beam-travelling carriage may further comprise a motor attached at the bottom surface of the top plate and arranged between the at least two laterally spaced first air bearings.

The beam-travelling carriage may be configured to travel along a beam having a U-shaped cross section and including a first sidewall and a second sidewall connected by a base. The motor may be arranged to travel inside channel formed by the first sidewall, the second sidewall and the base.

According to some embodiments, the beam-travelling carriage may further comprise a first cable connected at a first end to the top plate. The first cable may extend longitudinally from the top plate in a first direction. The beam-travelling carriage may further comprise a second cable connected at a first end to the top plate. The second cable may extend longitudinally from the top plate in a second direction, opposite to the first direction. The first cable and the second cable may be configured to together provide at least one of air, vacuum, electrical power, and signals to the beam-travelling carriage. A second end of the first cable and a second end of the second cable may be configured to be connected to a cable port at the beam.

The first and second cables may each comprise a plurality of cables. For example, the first cable and/or the second cable may each comprise a cover, envelope, or jacket, in which a plurality of cables may be arranged.

At least one of the first and second cables may be configured to provide air to the carriage for supplying the first and/or second air bearings with air. At least one of the first and second cables may be configured to provide vacuum to the carriage for supplying the second air bearings with vacuum. At least one of the first and second cables may be configured to provide electricity to the carriage for supplying the carriage and/or any equipment carried by the carriage with electricity. At least one of the first and second cables may be configured to provide convey signals to the carriage for conveying signals to the carriage and/or any equipment carried by the carriage.

Providing a first cable and a second cable extending in opposite longitudinal directions from the carriage may reduce vibrations and/or a positioning error of the carriage, as compared with providing cables extending in a single longitudinal direction from the carriage.

For example, each of the cables may exert a force on the carriage. By providing two cables at opposite ends of the carriage, the forces exerted on the carriage by the cables may be better balanced. The cables may for example each exert a longitudinal pulling force on the carriage.

Further, the weight of a cable may affect a center of gravity of the carriage. If only one cable is used, extending in one longitudinal direction, the force of the weight of the cable on the carriage may vary as the carriage travels along the beam. For example, the force of the weight of the cable on the carriage may vary from 0% at one end of the beam, to 100% at the opposite end of the beam. This may cause the position of the center of gravity to shift as the carriage travels along the beam, which may in turn cause the carriage to turn or tilt. By connecting two cables extending in opposite longitudinal directions from the carriage (or top plate), the forces exerted on the carriage by the weights of the cables may be exerted on both sides of the carriage. Further,

As the carriage travels along the beam, the weight of the two cables may balance each-other, such that the center of gravity is, at least more, stable.

For example, the first and second cables may be adapted to have equivalent weights. For example, a weight of the first cable and a weight of the second cable may differ by less than 15%, such as less than 10%, or less than 5%.

Arranging the cables of the carriage extending in both longitudinal directions, or at both ends of the carriage or top plate, may provide that fewer cables are arranged at each side of the carriage or top plate. Thus, a friction between the cables may be reduced, which may in turn reduce vibrations affecting the carriage.

The cable port may be arranged at a midpoint of the beam. The length of the cables may be adapted to allow the carriage to travel a specified distance along the beam, such as along the entire length of the beam. In a U-shaped beam, as described above, the cable port may be arranged inside the channel formed by the first sidewall, the second sidewall and the base. The first and second cables may at least partially be arranged inside the channel formed by the first sidewall, the second sidewall and the base.

According to some embodiments, the beam-travelling carriage may further comprise an optical head arranged at the side plate. The optical head may comprise projection optics for focusing a laser writing beam onto a substrate.

The beam-travelling carriage may be a pattern generation carriage, such as a microlithography carriage. The optical head may comprise optical components that direct and focus a writing beam onto the substrate. A final lens, or objective lens, may focus the beam onto the substrate and determines the resolution of the system. The focus may be set by adjusting a position of the final lens relative to the substrate's surface.

The present carriage may be especially suitable for microlithography systems, in which any microscopic, or nanoscopic, vibration or deviation may significantly affect the output of the process.

According to a second aspect of the present disclosure, a beam arrangement is provided. The beam arrangement comprises a beam-travelling carriage as defined by the first aspect of the present disclosure. The beam arrangement further comprises a horizontal beam along which the beam-travelling carriage is arranged to travel.

According to some embodiments, the horizontal beam may have a U-shaped cross section and include a first sidewall and a second sidewall connected by a base. The top plate of the beam-travelling carriage may be arranged to travel along respective upper edges of the first sidewall and the second sidewall. The first lateral surface of the horizontal beam may be an outer surface of the first sidewall.

The carriage may comprise at least two laterally spaced first air bearings, as previously described. The laterally spaced first air bearings may be positioned to align with the upper edges or sides of the first sidewall and the second sidewall.

According to some embodiments, the beam arrangement may further comprise a magnetic structure arranged inside a channel formed by the first sidewall, the second sidewall and the base. The magnetic structure may be arranged for interaction with a motor arranged at the bottom surface of the top plate of the beam-travelling carriage.

According to a third aspect of the present disclosure, a microlithography system is provided. The microlithography system comprises a stage configured to support a substrate. The microlithography system further comprises a beam arrangement in accordance with the second aspect of the present disclosure. The beam arrangement may include a beam-travelling carriage including an optical head, as described above in reference to the first aspect of the present disclosure. The horizontal beam may be arranged above the stage. The beam-travelling carriage may be arranged to travel along the horizontal beam, above the stage. The beam-travelling carriage may be arranged to travel along the horizontal beam to allow the projection optics of the optical head to focus the laser writing beam onto a substrate arranged on the stage.

As described above, with reference to the first and second aspect of the present disclosure, the beam carriage according to the present disclosure may travel along a beam with improved stability and reduced vibrations. Thus, a microlithography system in accordance with the third aspect of the present disclosure may provide improved position and/or focus accuracy of the writing beam. As a result, a microlithography system in accordance with the third aspect of the present disclosure may provide reduced mura in the resulting pattern.

It is noted that other embodiments using all possible combinations of features recited in the above-described embodiments may be envisaged. Thus, the present disclosure also relates to all possible combinations of features mentioned herein.

### Brief description of drawings

Exemplifying embodiments will now be described in more detail, with reference to the following appended drawings:
Figure 1 is a perspective view of a beam-travelling carriage, in accordance with some embodiments;
Figure 2 is a cross-sectional view of a hinge, in accordance with some embodiments;
Figure 3 is a perspective view of a beam-travelling carriage, in accordance with some embodiments;
Figure 4 is an illustration of a first air bearing, in accordance with some embodiments;
Figure 5 is an illustration of a second air bearing, in accordance with some embodiments;
Figure 6 is a cross-sectional view of a beam arrangement in accordance with some embodiments;
Figure 7 is a side view of a microlithography system, in accordance with some embodiments; and
Figure 8 is an illustration of a beam-travelling carriage in accordance with some embodiments.

As illustrated in the figures, the sizes of the elements and regions may be exaggerated for illustrative purposes and, thus, are provided to illustrate the general structures of the embodiments. Like reference numerals refer to like elements throughout.

### Detailed description

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

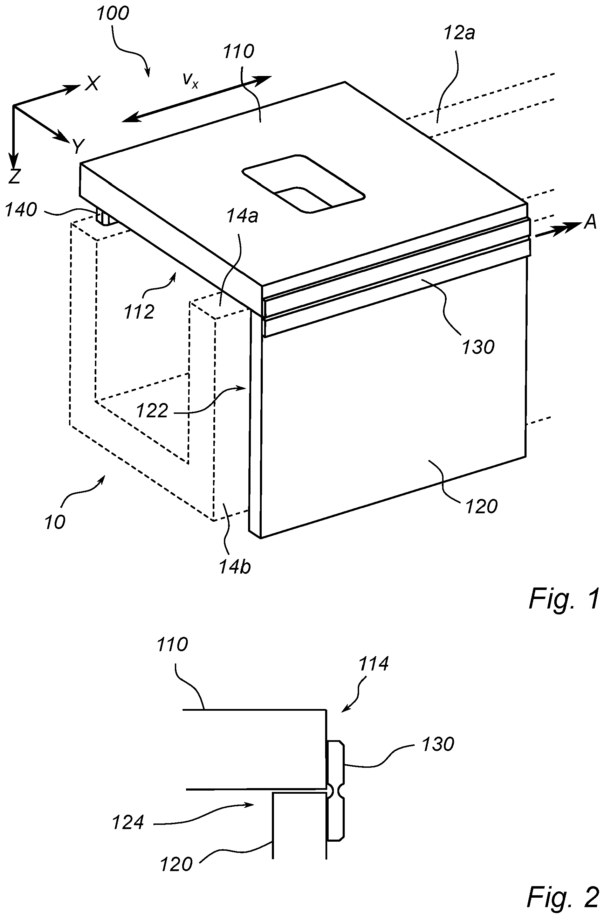

With reference to Figures 1-5, a beam-travelling carriage 100 in accordance with some embodiments, will be described. The illustrated example embodiment comprises a plurality of features, some of which may be optional within the scope of the present disclosure.

Figure 1 is a perspective view of a beam-travelling carriage 100, in accordance with some embodiments. Figure 1 illustrates the carriage 100 viewed from above, and from an external side of a side plate 120 of the carriage 100.

The beam-travelling carriage 100 is configured to travel vₓ along a beam 10, illustrated in Figure 1 with dashed lines. Figure 1 further defines a coordinate system X, Y, Z, such as a cartesian coordinate system. The coordinate system is defined such that the beam 10 extends along the X direction. The carriage 100 is arranged to travel along the beam 10 in the X direction. Thus, the X direction may be referred to as a direction of travel, or a longitudinal direction. The Y direction extends across the beam and may be orthogonal to the X direction. The Y direction may be referred to as a lateral direction. The Z direction extends downwards from a plane defined by the X and Y directions. For example, the Z direction may be orthogonal to both the X and the Y direction. The beam 10 may be horizontally arranged. Thus, the X direction may be horizontal, the Y direction may be horizontal, and the Z direction may be vertical.

The carriage comprises a top plate 110 and a side plate 120. The top plate comprises a bottom surface 112 configured to travel along an upper surface 12a, 14a, of the beam 10. The side plate 120 comprises a lateral surface 122 configured to travel along a first lateral surface 14b of the beam 10.

As is further illustrated in Figure 2, a first lateral edge 114 of the top plate is connected to a top or upper edge 124 of the side plate 120 by a hinge 130. The hinge 130 has a rotational axis A, extending parallel with the X direction. The side plate 120 may thus move relative to the top plate 110 and follow the lateral surface 14b of the beam 10 even if an angle between the first lateral surface 14b of the beam 10 and the upper surface 14a of the beam 10 is not constant along an extension of the beam. This movement of the side plate 120 relative to the top plate 110 may reduce tensions within the carriage 100.

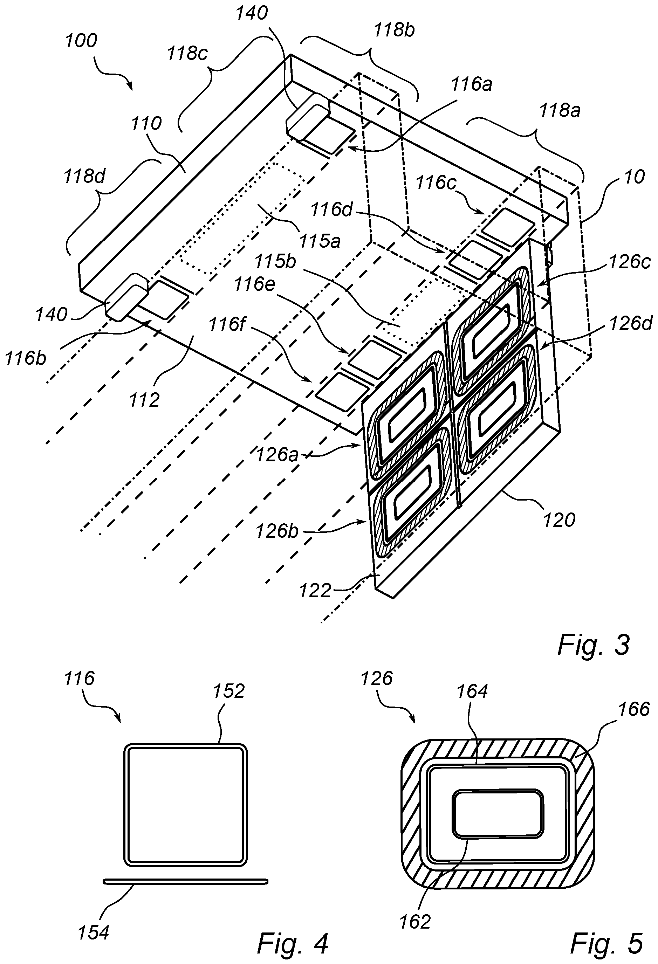

Figure 3 is another perspective view of the beam-travelling carriage 100. In Figure 3, the bottom side 112 of the top plate 110 and the lateral surface 122 of the side plate 120 are visible, and the beam 10 is indicated with dashed lines.

The bottom side 112 of the top plate 110 comprises a plurality of first air bearings 116a-f. The first air bearings 116a-f are arranged to enable linear motion of the top plate along the upper surface of the beam 10.

As is further illustrated in Figure 4, a first air bearing 116 comprises an air supply groove 152, and a ventilation groove 154. The air supply groove 152 and the ventilation grove 154 may be formed in the top plate 112. For example, the top plate 112 may be formed, manufactured, or provided, and the air bearing 116 may be formed within the top plate 112. The air bearing further comprises an air supply which is not illustrated. The air supply comprises a source of pressurized air, the flow of which may be controlled by a valve, also not illustrated. The air supply provides a flow of pressurized air through the air supply groove 152, thus forming an air film or cushion between the bottom surface 112 of the top plate 110 and the upper surface 14a, 16a of the beam, lifting the top plate above the beam 10. A thickness of the air film may be controlled by controlling the air pressure and/or the air flow via the air supply and/or the valve. The carriage may travel at least almost frictionlessly on the air film or cushion, along the top surface of the beam 10. The ventilation groove 154 provides an outlet through which air from the air cushion/film may be led away or ventilated. The ventilation groove 154 may provide or define a limit or border of the air bearing 116.

The first air bearings 116a-f may be biased towards the beam 10 by gravity and the weight of the carriage.

The air bearings 116a-f of the top plate 112 are laterally spaced. Four of the air bearings 116c-f are arranged in a first lateral region 118a of the bottom surface 112, or at a first lateral portion 118a of the bottom surface 112, which is arranged a at a first lateral edge 114 of the top plate 110. The first air bearings 116c-f arranged at the first lateral portion 118a of the top plate, are arranged to align with a top surface 14a, see Fig. 1, of the beam 10 when the carriage 100 is arranged on the beam 10. Two of the air bearings 116a-b are arranged in a second lateral region 118b of the bottom surface 112, or at a second lateral portion 118b of the bottom surface 112, which is arranged a at a second lateral edge of the top plate 110. The first air bearings 116a-b arranged at the second lateral portion 118a of the top plate, are arranged to align with a top surface 12a, see Fig. 1, of the beam 10 when the carriage 100 is arranged on the beam 10.

By arranging or forming a larger number of first air bearings 116c-f at the first lateral edge portion 114a, and a smaller number of first air bearings 116a-b at the second lateral edge portion 118b, an off-center weight distribution of the carriage 100 may be better balanced. As the side plate 120 is attached at the first edge of the side top plate 110, the first lateral edge portion 118a may be subject to a larger vertical gravitational force than the second lateral edge portion 118b. By providing a larger number of air bearings 116c-f at the first lateral edge portion 118a, a larger lifting force may be provided at the first lateral edge portion 118a, which may better balance the carriage 100, and may further reduce friction between the top plate 110 and the beam 10.

The air bearings 116a-f of the top plate 112 are longitudinally spaced. Three of the air bearings 116a, 116c, 116d, are arranged at a first longitudinal edge portion 118c of the bottom surface 112, or in a first longitudinal edge region 118c, such as a back portion of the bottom surface 112 in relation to the X direction defined in Figure 1. Three of the air bearings 116b, 116e, 116f, are arranged at a second longitudinal edge portion 118d of the bottom surface 112, such as in a second longitudinal edge region 118d, such as a front portion of the bottom surface 112 in relation to the X direction defined in Figure 1.

By arranging the first air bearings 116a-f at longitudinally spaced edge regions 118c, 118d, a weight of the carriage 110 may be better balanced.

The top surface 112 further comprises two damping surfaces 115a-b. A first damping surface 115a is arranged or formed between the longitudinally spaced first air bearings 116a, 116b in the second lateral edge region 118b. The first damping surface 115a is arranged or formed to align with the top surface 12a, see Fig.1, when the carriage 100 is arranged on the beam 10. A second damping surface 115b is arranged or formed between the longitudinally spaced first air bearings 116d, 116e in the first lateral edge region 118a. The second damping surface 115b is arranged or formed to align with the top surface 14a, see Fig.1, when the carriage 100 is arranged on the beam 10. The damping surfaces 115a, 115b may be formed in the bottom surface 112. For example, the damping surfaces 115a, 115b may be formed by lapping a region 115a, 115b to a desired structure and flatness.

The damping surfaces 115a, 115b may provide a similar film thickness as the air bearings 116a-f, but without the air flow. The damping surfaces 115a, 115b may damp vibrations between the carriage 100 and the beam 10.

The lateral side 122 of the side plate 120 comprises a plurality of second air bearings 126a-d. A surface area of the second air bearings 126a-d may be adapted to a size of the first lateral surface 14b of the beam 10. Specifically, the surface of the second air bearings 126a-d may be maximized to provide a high stiffness of the bearings 126a-d while using a relatively low supply pressure.

As is further illustrated in Figure 5, a second air bearing 126 comprises an air supply groove 162 and a ventilation groove 164 similar to the air supply groove 152 and ventilation groove 154 of the first air bearing 116 described above with reference to Figure 4. The air bearing 126 further comprises an air supply which is not illustrated. The air supply comprises a source of pressurized air, the flow of which may be controlled by a valve, also not illustrated. The air supply provides a flow of pressurized air through the air supply groove 162, thus forming an air film or cushion between the lateral surface 122 of the side plate 120 and the first lateral surface 14 b of the beam 10, which separates the side plate 120 from the beam 10. The ventilation groove 164 provides an outlet through which the air from the air cushion/film may be led away or ventilated. The ventilation groove 164 may provide or define a limit or border of an air cushion or air film of the air bearing 126.

However, in order to keep the carriage 100 in position on the beam 10 and prevent the carriage 100 from drifting laterally on the beam 10, the second air bearing 126 is biased or preloaded to balance the lateral pushing force from the air supply. In some embodiments, the second air bearing 126 may comprise a magnet, to magnetically bias or preload the air bearing 126. In such embodiments, the magnet pulls the side plate 120, and the carriage 100, towards the first lateral surface 14b and the beam 10. Figure 5, on the other hand, illustrates a vacuum biased air bearing 126. The air bearing 126 thus further comprises a vacuum groove 166, providing a negative pressure by withdrawing air. The negative pressure of the vacuum groove 166 pulls the side plate 120, and the carriage 100, towards the first lateral surface 14b and the beam 10.

In Figure 5, the vacuum groove 166 surrounds the air bearing surface formed by the air supply groove 162 and the ventilation groove 164. The vacuum groove 166 may provide further ventilation of the air provided through the air supply groove 162 to minimize an airflow leaking out outside the air bearing 126. Thus, the vacuum groove 166 may further define a limitation of the vacuum-biased air bearing 126.

A thickness of the air film provided between the side plate 120 and the lateral surface 14b may be controlled by controlling the air pressure and/or the air flow via the air supply and/or the valve. In case the air bearing 126 is controllably biased, the thickness of the air film provided between the side plate 120 and the lateral surface 14b may be controlled by controlling a biasing force of the air bearing 126. A thickness of the air film may determine, or be equivalent to, a distance between the first side plate 120 and the lateral surface 14b. The carriage 100 may travel at least almost frictionlessly on the air film or cushion, along the first lateral surface 14b of the beam 10.

The air supply groove 162, the ventilation groove 164 and the vacuum groove 166 may be integrally formed in the side plate 120. For example, the side plate 120 may be formed, manufactured, or provided, and the and the air bearing 126 may be formed within the side plate 120.

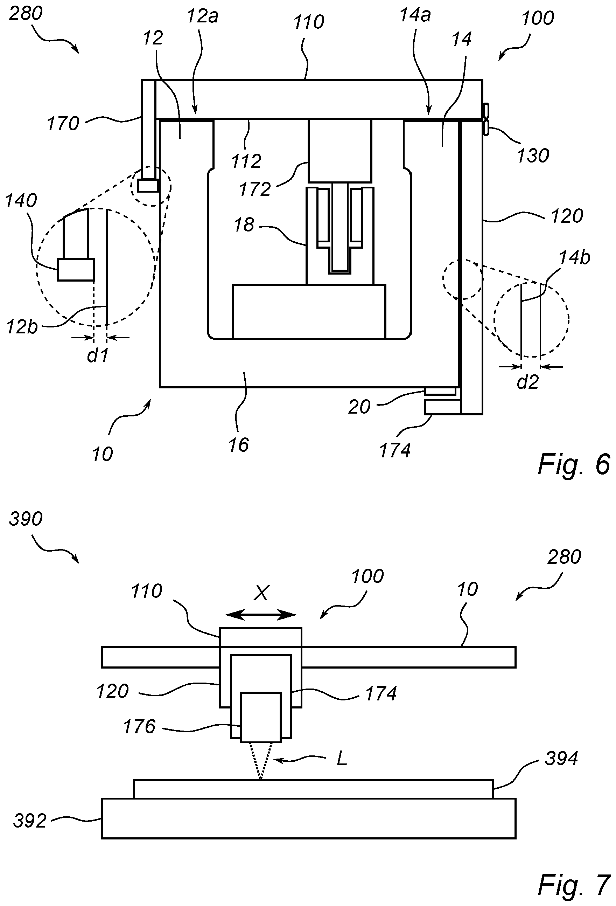

The biasing of the second air bearings 126a-d may prevent the carriage 100 from drifting laterally on the beam 10. Specifically, the second air bearings 126a-d may provide or maintain a lateral position of the carriage or the beam. However, if the biasing of the second air bearings 126a-d were to be interrupted, or in case of failed operation of the biasing of the second air bearings 126a-d, the carriage 100 may start to drift laterally, and ultimately fall off the beam 10. In order to prevent such an event from occurring, the carriage 100 is provided with two emergency stopping elements 140. These emergency stopping elements are arranged at the second lateral edge 118b of the bottom surface 112 of the top plate 110. The stopping elements 140 extend downwards from the top surface and are arranged and configured to engage with a second lateral edge surface 12b, see Fig. 6, in case the carriage 100 were to move laterally, in the positive Y direction defined in Figure 1. The stopping elements 140 will be further discussed below in reference to Figure 6.

With reference to Figure 6, a beam arrangement 280 and a beam-travelling carriage 100, in accordance with some embodiments, will be described.

Figure 6 illustrates a cross-sectional view of the beam arrangement 280. The beam arrangement 280 comprises a beam 10 and a beam-travelling carriage 100. These may be equivalent to the beam 10 and beam-travelling carriage 100 described above with reference to Figures 1-5.

The beam 10 has a U-shaped cross-section, formed by a first sidewall 12 (or side 12) and a second sidewall 14 (or side 14) connected by a base 16. The beam 10 may be referred to as a U-beam 10. Each of the sidewalls 12, 14 has a respective top or upper surface 12a, 14a, configured to allow the top plate 110 of carriage 100 to travel thereon. The second side 14 has a first lateral surface 14b, configured to allow the second plate 120 of the carriage 100 to travel there along. For example, the top surfaces 12a, 14a and the first lateral surface 14b, may have a surface texture, flatness or smoothness adapted to allow the carriage 100 to travel along the beam 10.

The two sidewalls 12, 14 and the base 16 together form a channel extending along the extension of the beam, i.e., in the X-direction defined in Figure 1. The carriage 100 further comprises a motor 172 arranged at the bottom surface 112 of the top plate 110. A magnetic structure 18 is arranged along the channel formed by the beam 10, for interaction with the motor 172. The motor 172 may for example comprise a coil assembly, such that the motor 172 may drive the carriage 100 along the beam 10 through interaction of the coil assembly with the magnetic structure 18.

The carriage 100 may further comprise an encoder sensor 174 for measuring a position of the carriage 100 along the beam 10. The beam 10 may be provided with a ruler or scale 20, such as a glass scale, along which the encoder sensor 174 may measure the position. In Figure 6, the scale 20 is arranged at a bottom surface of the beam 10, and the encoder sensor 174 is arranged at a bottom edge of the side plate 120.

As is illustrated in Figure 6, the motor 172 is arranged off-center on the top plate. This is to illustrate that the motor 172 is preferably arranged at the center of gravity of the carriage 100, which is located off-center toward the side plate 120.

As is illustrated in Figure 6, the carriage 100 further comprises a counterweight 170 arranged at the second lateral edge (118b in Figure 3). The counterweight 170 may have a weight adapted to balance the carriage 100. For example, the weight of the counterweight 170 may be adapted to move a center of gravity of the carriage 100 in line with the motor 172. By arranging the motor 172 at the center of gravity, vibrations may be further reduced, and an efficiency of the motor 172 may be increased. The counterweight 170 may for example comprise a plate of a heavy material, such as a steel plate. Other components or units, such as parts of a piece of equipment carried by the carriage, may be arranged at the counterweight, and form part of the counterweight.

In Figure 6, the stopping element 140 is arranged at the counterweight 170. However, it will be appreciated that the following description also applies to embodiments at which the stopping element 140 is arranged directly at the bottom surface 112, or otherwise extending from the bottom surface 112. During use, and specifically during operation of the second air bearing(s) 126, the stopping element 140 is arranged to travel along the second lateral surface 12b of the beam 10, at a first distance d1 from the beam 10. In other words, during normal operation, the stopping element 140 is arranged to travel along the second lateral surface 12b of the beam 10, without touching or being in contact with the second lateral surface 12b.

As is also illustrated, during normal operation of the second air bearing(s) 126, the air bearings 126a-d provide an air film between the side plate 120 and the first lateral surface 14b of the beam 10. As a result, the side plate 120 travels at a second distance d2 from the first lateral surface 14b of the beam 10, corresponding to a thickness of the air film. The stopping element 140 is arranged at a defined distance from the side plate 120. More specifically, the stopping element 140 is arranged at a distance from the side plate 120 corresponding the first distance d1 and the second distance d2 added to a width of the beam 10. The width of the beam may be equivalent to a distance between the first lateral surface 14b, and the second lateral surface 12b.

Thus, if the second air bearings were to fail, the carriage 100 the stopping element 140 would prevent the carriage 100 from sliding laterally more than the distance d1 in the positive Y direction defined in Figure 1, and the side plate would prevent the carriage from sliding laterally more than the distance d2 in the negative Y direction defined in Figure 1.

With reference to Figure 7, a microlithography system 390, a beam arrangement 280, and a beam-travelling carriage 100, in accordance with some embodiments, will be described.

Figure 7 is a side view of a microlithography system, in accordance with some embodiments. The microlithography system 390 comprises a stage 392 configured to support a substrate 394, and a beam arrangement 280. The beam arrangement 280 may be equivalent to the beam arrangement 280 described above with reference to Figure 6. The beam 10 is arranged, horizontally, above the stage 392.

The beam-travelling carriage 100 may be equivalent to any of the carriages 100 described above with reference to preceding figures, except in that it further comprises an optical head 174 arranged at the side plate 120. The optical head 174 comprises projection optics 176 for focusing a laser writing beam L onto the substrate 394. The substrate 394 may for example comprise a photo-sensitive resist layer, which may be developed upon exposure by the laser writing beam L (or laser beam L, or optical beam L). The carriage 100 is arranged to travel along the beam 10 to allow the projection optics 176 of the optical head 174 to focus the laser writing beam L onto the substrate 394 arranged on the stage. By travelling along the beam 10 (or X-beam 10), the projection optical head 174 may focus the laser beam at different positions on the substrate 394 along the beam 10 and along the X direction.

The microlithography system 390 may further provide relative movement between the optical head 174 and the substrate 394 along the Y direction, defined in Figure 1. For example, the stage 392 may be configured to move the substrate 394 underneath the beam 10 along the Y direction.

The microlithography system 390 may further comprise means for modulating the laser beam L. By modulating the laser beam L, different positions on the photo-sensitive resist layer may be differently exposed to the laser beam, and thus develop differently, thereby forming a pattern on the substrate 394.

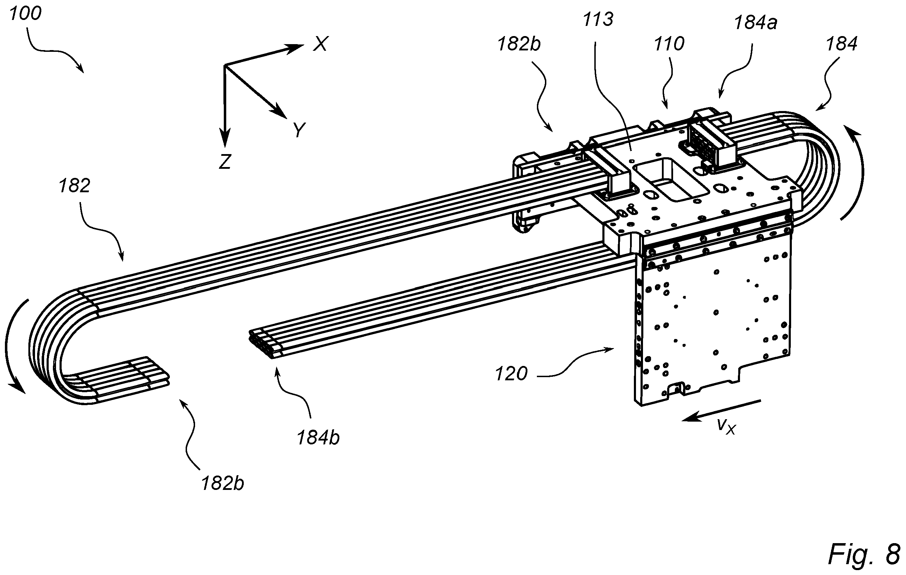

With reference to Figure 8, a beam-travelling carriage 100, in accordance with some embodiments, will be described.

Figure 8 is a perspective view of the beam-travelling carriage 100. The beam-travelling carriage 100 may be equivalent to any of the beam-travelling carriages 100 described above with reference to Figures 1-7, except in that it further comprises a first cable 182 and a second cable 184.

The first cable 182 and the second cable 184 may each comprise a plurality of cables. Thus, the first cable 182 and the second cable 184 may each comprise a cover, envelope, or jacket, in which a plurality of cables may be arranged. The first cable 182 and the second cable 184 may together provide the carriage 100, and any equipment arranged thereon, with air, vacuum, electrical power, and/or signals.

A first end 182a of the first cable 182 is connected to the top plate 110 of the carriage 100. Specifically, the first end 182a of the first cable 182 connects to a top surface 113 of the top plate 110. The first cable 182 extends longitudinally, along the negative X direction, from the carriage's first plate 110. A second end 182b of the first cable 182 may be configured to be connected to a cable port (not illustrated) at the beam. For example, the second end 182b of the first cable 182 may be configured to be connected to a cable port inside a channel formed by a U-beam, as described above with reference to Figure 6.

A first end 184a of the second cable 184 is connected to the top plate 110 of the carriage 100. Specifically, the first end 184a of the second cable 184 connects to a top surface 113 of the top plate 110. The second cable 184 extends longitudinally, along the positive X direction defined in Figure 1, from the carriage's first plate 110. A second end 184b of the second cable 184 may be configured to be connected to a cable port (not illustrated) at the beam. For example, the second end 184b of the second cable 184 may be configured to be connected to a cable port inside a channel formed by a U-beam.

The second ends 182b, 184b of the first and second cables 182, 184, may be configured to be connected to a cable port, inside the channel, at a mid point of the beam 10. A length of each of the first and second cables 182, 184, may be adapted to allow the carriage 100 to travel along a full length of the beam 10.

In Figure 8, the carriage 100 is illustrated as being positioned at an end of a beam (not illustrated). As the carriage 100 travels, as indicated by the arrow vx, in the negative X direction, the first and second cables 182, 184 will roll over, as indicated by the curved arrows. When the carriage 100 reaches a second end of the beam, a majority of the first cable 182 may extend along a bottom of the channel, and a majority of the second cable 184 may extend approximately in a plane of the top plate. The first and second cables 182, 184 may be referred to as rolling cables.

The person skilled in the art realizes that the present invention by no means is limited to the preferred embodiments described above. On the contrary, many modifications and variations are possible within the scope of the appended claims.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A beam-travelling carriage (100) comprising:
a top plate (110) having a bottom surface (112) on which at least one first air bearing (116) is arranged for enabling linear motion of the top plate along an upper surface (14a) of a horizontal beam (10);
a side plate (120) having a lateral surface (122) on which at least one second air bearing (126) is arranged for enabling linear motion of the side plate along a first lateral surface (14b) of the horizontal beam; and
a hinge (130) connecting a first lateral edge (114) of the top plate to an upper edge (124) of the side plate, wherein
the at least one second air bearing is preloaded for maintaining a lateral position of the carriage on the horizontal beam.

2. The beam-travelling carriage of claim 1, further comprising:
at least one stopping element (140) extending downward from the top plate at a second lateral edge (118b) of the top plate, the at least one stopping element being arranged:
to be positioned at a first distance (d1) from a second lateral surface (12b) of the horizontal beam during operation of the at least one second air bearing; and
to prevent lateral movement of the carriage in case of failed operation of the at least one second air bearing.

3. The beam-travelling carriage of any of the preceding claims, further comprising a counterweight (170) arranged at a second lateral edge of the top plate.

4. The beam-travelling carriage of any of the preceding claims, wherein said at least one second air bearing is vacuum preloaded or magnetically preloaded.

5. The beam-travelling carriage of any of the preceding claims, wherein said at least one first air bearing is integrally formed in the top plate, and wherein said at least one second air bearing is integrally formed in the side plate.

6. The beam-travelling carriage of any of the preceding claims, wherein the at least one first air bearing comprises at least two longitudinally spaced first air bearings (116a, 116b).

7. The beam-travelling carriage of claim 6, wherein the bottom surface of the top plate comprises a damping surface (115) between said at least two longitudinally spaced first air bearings.

8. The beam-travelling carriage of any of the preceding claims, wherein the at least one first air bearing comprises at least two laterally spaced first air bearings (116a, 116c).

9. The beam travelling carriage of claim 8, wherein the at least two laterally spaced first air bearings comprises a first number of first air bearings (116c-f) arranged at a first lateral portion of the bottom surface of the top plate and a second number of first air bearings (116a-b) at a second lateral portion of the bottom surface of the top plate, wherein the first number is larger than the second number.

10. The beam-travelling carriage of any of claims 8 or 9, further comprising a motor (172) attached at the bottom surface of the top plate and arranged between the at least two laterally spaced first air bearings.

11. The beam-travelling carriage of any of the preceding claims, further comprising:
a first cable (182) connected at a first end (182a) to the top plate, and extending longitudinally from the top plate in a first direction; and
a second cable (184) connected at a first end (184a) to the top plate, and extending longitudinally from the top plate in a second direction, opposite to the first direction;
wherein the first cable and the second cable are configured to together provide at least one of air, vacuum, electrical power, and signals to the beam-travelling carriage; and
wherein a second end (182b) of the first cable and a second end (184b) of the second cable are configured to be connected to a cable port at the beam.

12. The beam-travelling carriage of any of the preceding claims, further comprising an optical head (174) arranged at the side plate, the optical head comprising projection optics (176) for focusing a laser writing beam (L) onto a substrate (394).

13. A beam arrangement (280) comprising:
a beam-travelling carriage (100) as defined in any of the preceding claims; and
a horizontal beam (10);
wherein the beam-travelling carriage is arranged to travel along the horizontal beam.

14. The beam arrangement of claim 13, wherein said horizontal beam has a U-shaped cross section and includes a first sidewall (12) and a second sidewall (14) connected by a base (16); wherein
the top plate of the beam-travelling carriage is arranged to travel along respective upper edges (12a, 14a) of the first sidewall and the second sidewall; and
wherein the first lateral surface (14b) of the horizontal beam is an outer surface of the first sidewall.

15. A microlithography system (390) comprising:
a stage (392) configured to support a substrate; and
a beam arrangement (280) as defined in any of claims 13-14, including the beam-travelling carriage defined in claim 12; wherein
the horizontal beam is arranged above the stage; and
the beam-travelling carriage is arranged to travel along the horizontal beam to allow the projection optics (176) of the optical head (174) to focus the laser writing beam (L) onto a substrate (394) arranged on the stage.
